# EUROPEAN PATENT SPECIFICATION

(11) **EP 2 478 605 B1**
(45) Date of publication and mention of the grant of the patent: **25.11.2015**
(21) Application number: 09765163.2
(22) Date of filing: 18.09.2009
(51) Int. Cl.: H02H 3/04

(54) **METHOD AND SYSTEM FOR MANAGING AN ELECTRICAL JUNCTION BOX**
VERFAHREN UND SYSTEM ZUR HANDHABUNG EINES ELEKTRISCHEN ANSCHLUSSKASTEN
PROCÉDÉ ET SYSTÈME DE GESTION DE BOÎTE DE JONCTION ÉLECTRIQUE

(43) Date of publication of application: 25.07.2012
(73) Proprietor: Volvo Lastvagnar AB, 405 08 Göteborg (SE)
(72) Inventor: SCHMIDT, Roger, F-69100 Villeurbanne (FR); LEROY, Frédéric, F-69008 Lyon (FR); MOLINA, Franck, Paul, Germain, F-01240 Dompierre Sur Veyle (FR)
(74) Representative: Faucheux, Jérôme
(86) International application number: PCT/IB2009/007273
(87) International publication number: WO 2011/033335

(56) References cited:
- US-A1- 2006 077 607

## Description

### TECHNICAL FIELD

The invention relates to a method for managing an electrical junction box which is arranged in a motor vehicle and which has electrical components of the fuse type and/or of the relay type. Besides, the invention relates to a system for managing such an electrical junction box.

### BACKGROUND

A junction box usually comprises several electrical components of the fuse and/or relay type. The fuses have different electrical properties and different connecting arrangements within the junction box. On the one hand, some main fuses are for instance directly connected to the power supply line coming from the vehicle accumulator. The main fuses are therefore constantly live, i.e. constantly under voltage, even when the motor vehicle is in its idle mode. On the other hand, some secondary fuses are connected downwards of relays controlling their power supply. Hence, the secondary fuses are intermittently live, depending on the needs of operation of their electrical circuits.

FR-A-2 730 814 describes a system for diagnosing the possible defects of the main fuses in a junction box. The system of FR-A-2 730 814 comprises means for checking whether or not every main fuse is defective, means for determining which is the defective fuse and means for displaying the identification of the defective fuse.

When a main fuse occurs to be defective, the vehicle driver is most probably isolated on the road. The driver must stop the vehicle, get the identification of the defective main fuse and chose a replacement fuse in a spare fuse box. However, in case the spare fuse box is empty or lacks the proper replacement fuse, the driver is compelled to select a replacement fuse among the fuses already plugged in the junction box.

Document US 2006/077607 discloses the preamble of the subject-matter of independent claim 11.

### SUMMARY

One of the purposes of the invention is to solve the here-above listed drawbacks, by proposing a method or a system for managing a junction box, which enables the driver to quickly and reliably select a replacement component.

To achieve this purpose, a subject matter of the invention is a method for managing a junction box arranged in a motor vehicle and having electrical components of the fuse and/or relay type, said method comprising the steps of:
a) monitoring electrical quantities pertaining to said components so as to check whether one of said components is defective;
b) determining which is the defective component;
c) generating a first signal for the identification of the defective component;
d) selecting, among said components, at least one replacement component adapted to operatively replace said defective component; and
e) generating a second signal for the identification of the at least one replacement component.

A management method according to the invention thus not only permits a comprehensive diagnostic about the defective component, but it also fully and accurately supports the driver in the replacement operations by the selection and identification of the replacement component.

According to other advantageous but optional features, considered in isolation or in any technically feasible combination:
- the selection step d) results in the selection of several replacement components;
- this method also comprises the steps f) of assigning to several individual components a rank representative of the importance of the electrical circuit to which this individual component is connected, and g) of comparing the respective ranks of the selected replacement components for the identification of at least one replacement component having the lowest possible rank;
- the assignment step f) can be performed only once before the beginning of the service life of the motor vehicle;
- alternatively, the assignment step f) can be performed regularly during the service life of the motor vehicle, said rank depending on the operating conditions of the motor vehicle;
- the method also comprises the steps of transmitting said first signal to an interface device located in the motor vehicle, so as to provide the driver with the identification of the defective component; of transmitting said second signal to said interface device located in the motor vehicle, so as to provide the driver with the identification of a replacement component;
- the method also comprises the steps of transmitting said first signal to a receiver remote from the motor vehicle, so as to provide an organization with the identification of the defective component; of transmitting said second signal to said receiver, so as to provide said organization with the identification of a replacement component.
- the method also comprises the step of recording in a memory data relating to the identification of the defective component, the identification of the selected replacement component, the date of defect and/or the completion of a replacement operation.
- monitoring step a), for a component, consists in measuring electrical tension and/or current at a predetermined test point connected to said component;
- when a fuse is connected downwards of a relay, said electrical tensions and/or currents are measured when the relay is in its conducting position.

Besides, another subject matter of the invention is a system for managing a junction box arranged in a motor vehicle and having electrical components of the fuse and/or relay type, said system comprising:
- means for monitoring electrical quantities pertaining to said components so as to check whether one of said components is defective;
- means for determining which is the defective component;
- means for generating a first signal for the identification of the defective component;
- means for selecting, among said components, at least one replacement component adapted to operatively replace said defective component; and
- means for generating a second signal for the identification of the at least one replacement component.

### BRIEF DESCRIPTION OF THE DRAWINGS

The invention will be well understood and its advantages will also appear from the following description, only given by way of non-limiting example and with reference to the annexed drawings, among which:
- figure 1 is a schematic view of the main electrical devices present in the cab of a motor vehicle, among which stands an electrical junction box managed by a method according to the invention;
- figure 2 is a front view of such a junction box having several electrical components;
- figure 3 is a schematic representation of the junction box of figure 2 identifying a defect which has been handled by a method according to a first embodiment of the invention;
- figure 4 is a schematic representation of the junction box of figure 2 identifying a defect which has been handled by a method according to a second embodiment of the invention.

### DESCRIPTION OF SOME EMBODIMENTS

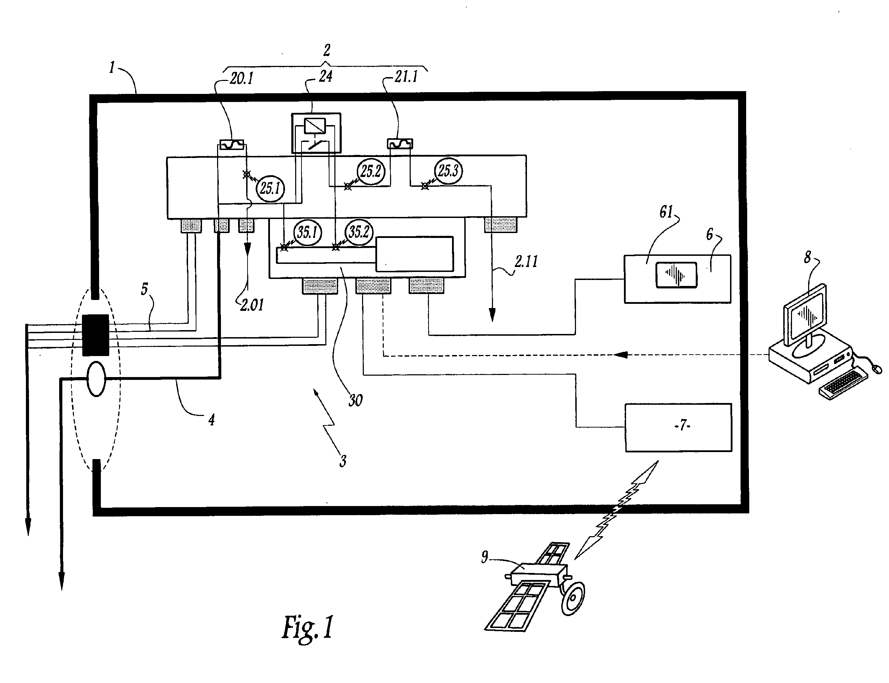

Figure 1 schematically depicts a cab 1 of a motor vehicle. Cab 1 contains a junction box 2 and a system 3 for managing the junction box 2. Junction box 2 may also be termed electrical junction box or "Fuse and Relay Center". The system 3 is operated in compliance with a method according to the invention for managing the junction box 2.

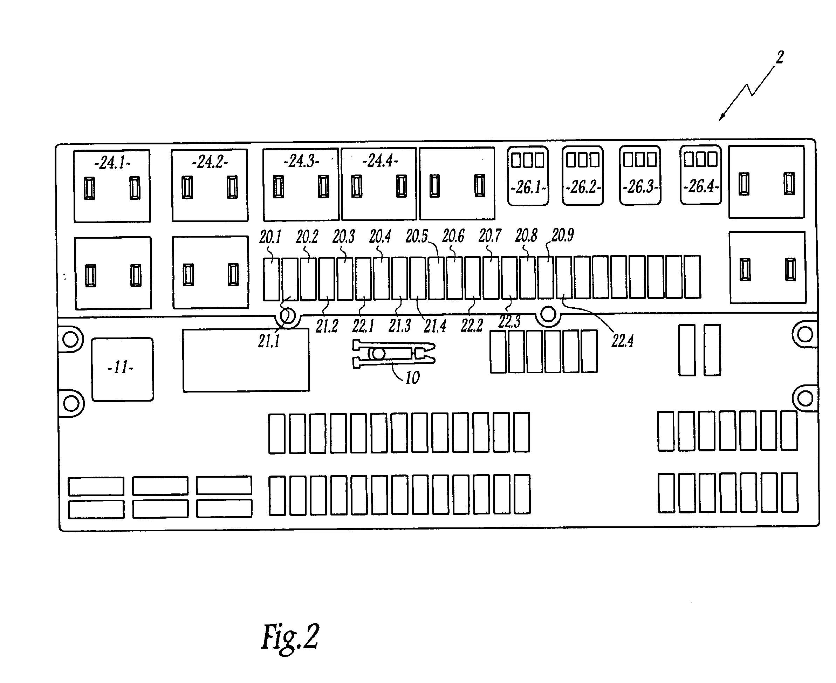

As can be seen on figures 1 and 2, junction box 2 has various electrical components, among which some fuses and some relays. There are three different categories of fuses, depending for example on their breaking capacities:
- large fuses 20.1, 20.2, 20.3, 20.4, 20.5, 20.6, 20.7, 20.8, 20.4, 20.9,
- medium fuses 21.1, 21.2, 21.3 and 21.4 and
- small fuses designated in groups by numeral references 22.1, 22.2, 22.3 and 22.4.

Large fuses 20.1 to 20.9 are called "large" because they protect electrical circuits carrying large currents, say 50A. Medium fuses 21.1 to 21.4 are called "medium" because they protect electrical circuits carrying medium currents, say 20A. Small fuses 22.1 to 22.4 are called "small" because they protect electrical circuits carrying small currents, say 10A.

Junction box 2 is connected to a power supply line 4 which brings current from the vehicle accumulator. Junction box 2 is also connected to the ground and to the chassis harness via cables 5.

Junction box 2 also comprises several relays, one illustrated on figure 1 by reference numeral 24.1 and several illustrated on figure 2 and hereafter described. Relay 24.1 is electrically controlled to selectively close and open its circuit 2.11, so as to control the power supplied thereto, conducting to a not shown electric device of the motor vehicle. Relay 24.1 hence controls the power supply to medium fuse 21.1.

As can be seen on figure 2, junction box 2 can also have two different categories of relays, depending for example on the current they can carry:
- large relays 24.1, 24.2, 24.3, 24.4, and
- small relays 26.1, 26.2, 26.3, 26.4.

Large relays 24.1 to 24.4 are called "large" because they protect electrical circuits carrying large currents, say up to 50A. Small relays 26.1 to 26.4 are called "small" because they protect electrical circuits carrying small currents, say 10A.

When an electrical component occurs to be defective, the corresponding circuit cannot function properly until the defective component has been replaced. In the present application, the words "defect" and "defective" refer to any malfunction of an electrical component, be it a blow of a fuse or a bad contact in a fuse or in a relay or else.

To handle such a defect or failure, a management system 3 according to the invention carries out a management method according to the invention. The management system 3 comprises a vehicle master control unit (VMCU) or control unit 30 which is connected, or herein even plugged, to junction box 2. Control unit 30 can comprise an interface having one or several electronic switches and a memory. Control unit 30 controls some lines connecting junction box 2 to control unit 30, so as to carry out some steps of a management method according to the invention.

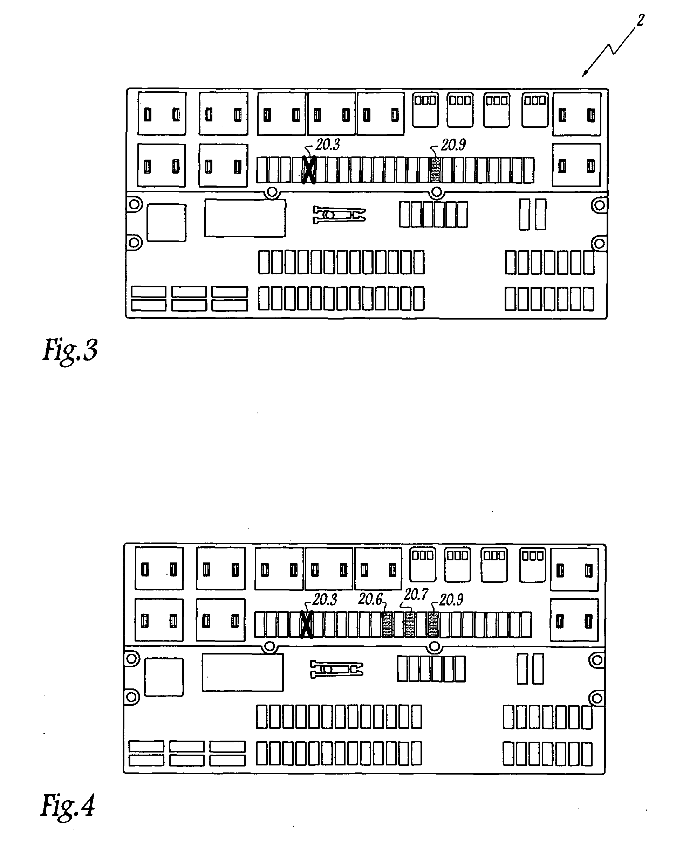

Figure 3 illustrates various steps of such a management method permitting to troubleshoot a defect of an electrical component of the fuse and/or relay type. Such a management method comprises the steps of:
a) Monitoring electrical quantities pertaining to the components 20.1 to 20.9, 21.1 to 21.4, 22.1 to 22.4, 24.1 to 24.4 and 26.1 to 26.4, so as to check whether one of the components is defective. Such a monitoring can be performed at a predetermined frequency or even continuously. The electrical quantities that may be monitored are the voltage and the current at a predetermined test point connected to this component. Junction box 2 has several test points to measure voltage and/or current, some of them being represented on figure 1 by reference numerals 25.1, 25.2, 25.3, 35.1 and 35.2.
b) Determining which is the defective component. This determination can be achieved by measuring voltage and/or current for every single electrical component put in its operating mode, e.g. after putting a relay controlling the circuit of a fuse in its current conducting position. In the case of figure 3, the voltage and/or current passing through medium fuse 21.1 are measured after closing relay 24. For example, after completion of this determination step b), the defective component comes out to be the large fuse 20.3 of medium rank.
c) Generating a first signal for the identification of defective large fuse 20.3. Such a signal can be of various natures, say electrical, electromagnetical or optical. In a first embodiment, this first signal can be transmitted to an interface device 6 located in the cab 1, say a loud speaker or an LCD display depicting a junction box 2. The first signal is then converted to a message to the driver, so as to provide him with the identification of defective large fuse 20.3. Such a message can be audio or visual, say light, characters or colour code. Then, the following steps are implemented:
d) Selecting, among the other active components 20.1 to 20.9, 21.1 to 21.4, 22.1 to 22.4 and 24, at least one replacement component adapted to operatively replace the defective large fuse 20.3. This selection is made among the operable components, i.e. the components which have not been determined as being defective. Besides, the control unit 30 makes this selection among components which can operatively replace the defective large fuse 20.3. The adverb "operatively" means that the replacement component(s) must have electrical properties, say braking capacity, in compliance with the electrical properties of the defective large fuse 20.3. For instance, a medium current fuse 21.1 to 21.4 of 20A braking capacity shall be replaced only by another medium current fuse 21.1 to 21.4 also having a 20A braking capacity. In the example of figure 3, the control unit 30 selected large fuse 20.9 as replacement component. The adjective "active" relates to an electrical component which is electrically connected to other electrical component(s), unlike spare components. Thus, when junction box 2 is in service, an active component carries current and/or holds voltage. An active component can be constantly live or not, operative or defective. An active component stops being active as soon as it is "unplugged" from its electrical circuitry.
e) Generating a second signal for the identification of large fuse 20.9. Like the first signal, this second signal can be transmitted to the driver by means of the interface device 6 displaying on the instrument cluster 61.

As schematically represented on figure 3, after completion of the here-above described steps a) to e) of a management method according to the invention, the cluster 61 provides the driver with the identification of the defective large fuse 20.3 and with the identification of the replacement large fuse 20.9.

According to a variant to the invention, one or both of steps d) of selecting and e) of identifying can be implemented upon request by the driver. For example, the driver may actuate a control interface to request implementation of steps d) and/or e). Hence, the completion of steps d) and/or e) can occur a while after step b) has been completed.

Hence, the driver can make the replacement of defective large fuse 20.3 by the replacement large fuse 20.9. It is easy and quick for him to unplug these two large fuses 20.3 and 20.9 from the junction box and to plug replacement large fuse 20.9 in lieu of large fuse 20.3. To plug and unplug fuses, the driver can use a fuse clamp 10.

Optionally, prior to this replacement operation, the driver may plug the replacement large fuse 20.9 onto a fuse tester 11 for testing its operative state.

In the present application, the noun "driver" stands for every operator in charge of carrying the replacement of the defective component. Such an operator can be the vehicle dealer or else.

As can be seen on figure 4 and according to an advantageous aspect of the invention, during selection and identification steps d) and e) several replacement components, say large fuses 20.6, 20.7 and 20.9, may be selected and identified. These replacement components 20.6, 20.7 and 20.9 are adapted to operatively replace the defective component 20.3. Indeed, large fuses 20.6, 20.7 and 20.9 can operatively replace defective large fuse 20.3, because they have compliant electrical properties. In this embodiment, the final selection of a single replacement component is left up to the driver.

According to another embodiment of a management method according to the invention, the method also comprises an assignment step f) of assigning individually to the components a rank representative of the importance of the electrical circuit to which the indivual component is connected.

Indeed, apart from the differentiation of their "dimensions", the relays 24 and the fuses 20.1 to 20.9, 21.1 to 21.4 and 22.1 to 22.4 can be classified or ranked depending upon the importance of the electrical circuit they respectively protect, i.e. to which they are respectively connected. There can be as many different ranks as there are components, i.e. fuses and/or relays. The rank can be a number increasing with the importance allocated to the electric device to which the electrical circuit supplies current. Accordingly, a large fuse can get a higher rank than a medium fuse and a small fuse can get a higher rank than a large fuse.

For instance, large fuse 20.1 protects a circuit 2.01 conducting current from the power supply line 4 to the headlights, whereas medium current fuse 21.1 protects a circuit 2.11 conducting current to the car radio. Hence, large fuse 20.1 gets a higher rank than medium fuse 21.1. In other words, more importance is allocated to large fuse 20.1 than to medium fuse 21.1. Other examples of high rank fuses are the ones protecting the electric and electronic systems controlling the braking devices, the engine or the airbags, or safety related circuits. Some examples of low rank fuses are the ones protecting the vehicle radio, the electric windows, or other comfort related devices.

Some fuses, usually high rank fuses, are constantly live, because they are directly connected to the power supply line 4. Some other fuses, usually low rank fuses, are intermittently live, because their respective circuits are controlled by relays. Hence, when a defect of a high rank fuse, occurs, the failure has important consequences. When a defect of a low rank fuse, occurs, the failure has less important consequences.

The method achieving the assignment step f) also comprises a step g) of comparing the respective ranks of the selected replacement components, say large fuses 20.6, 20.7 and 20.9 in the example of figure 4, for the identification of at least one replacement component having the lowest possible rank. Once the replacement component has been removed from its dedicated circuit, the electric device, e.g. the vehicle radio, connected thereto can not function until a new component is plugged onto junction box 2.

After the here-above described selection step e) resulted in a selection of several replacement components, the comparison step g) designates a replacement component of low rank, say the vehicle radio fuse or the electric windows fuse. Thus, the rank of large fuse 20.6 can be lower than the rank of large fuse 20.7 or 20.9. Therefore, the comparison step g) results in the selection of large fuse 20.6 as replacement component.

Such a rank comparison ensures that the driver will not disconnect an important electrical component pertaining to a safety critical electric device.

Besides, the here-above described assignment step f) can be performed only once before the beginning of the service life of the motor vehicle, i.e. the ranks are set at the factory or at the vehicle dealer. In this case, the ranks assigned to the respective electrical components do not change during the service life of the motor vehicle. The resulting rank assignment is said to be "static".

Alternatively, the assignment step f) can be performed regularly during the service life of the motor vehicle and can depend on the current operating conditions of the motor vehicle, e.g. sunny or rainy weather or other vehicle parameter(s), like vehicle speed and/or time of day. The resulting rank assignment, or reassignment, is said to be "dynamic". As an example, the rank of a fuse controlling the wipers may be low when a sensor indicates dry windshield, but high when the sensor indicates wet windshield.

In the present application, the adverb "regularly" refers to a relatively high frequency, say one rank reassignment per minute. The reassignment frequency may also be lower and, for instance, the ranks can be reassigned only when some sensors inform the control unit 30 that the operating conditions of the motor vehicle have changed.

According to another embodiment, apart from transmitting the first and second signals to the interface device 6 intended for the driver, a method according to the invention can also comprise the steps of:
h) Transmitting the first signal to a receiver remote from the motor vehicle, so as to provide an organization with the identification of the defective component, say large fuse 20.3. The motor vehicle is equipped with a communication gateway 7 adapted to communicate with the remote receiver, e.g. via a satellite 9.
i) Transmitting the second signal to the remote receiver, so as to provide the organization with the identification of every selected replacement component, say large fuses 20.6, 20.7 and 20.9.

This transmissions steps j) and k) permit to the organization, e.g. an assistance center or a vehicle dealer, to assist the driver in the replacement operations. The transmission steps j) and k) also permit to a customer service to gather statistics relating to the defects occurred in all the vehicles of a given fleet.

Besides, according to another embodiment of a management method according to the invention, the method can also comprise a step of:
j) Recording in a memory 32 data relating to the identification of the defective component, say large fuse 20.3, the identification of the selected replacement component, say large fuse 20.9, the date of defect and/or the completion of the replacement operation. In the embodiment of figure 1, the memory 32 is coupled with control unit 30.

This permits to keep track of the defects that occurred to junction box 2, in order to retrieve details about these defects, for instance in case of legal issue. A customer service or a vehicle dealer may also connect a computer 8 to the management system 30, in order to retrieve such details. Besides, the vehicle dealer or the customer service can provide the vehicle with a new spare component corresponding to the one used in the replacement operations.

A management method or a management system according to the invention enables the driver to quickly and reliably select a replacement component, eliminating the needs for going through the reading of the user's manual or the risk of the driver selecting a wrong replacement component.

The invention can be applied to any kind of motor vehicle having an electrical junction box, for instance a truck, a car, a boat, or any kind of agricultural or construction equipment vehicle such as loaders, excavators, tractors, compactors, etc...

The management method and the management system described in relation with figures 3 and 4 apply to a defective fuse. However, a management method or a management system according to the invention can also apply to relays 24.1 to 24.4 and 26.1 to 26.4 or to any other kind of electrical component.

## Claims

1. A method for managing a junction box (2) arranged in a motor vehicle and having electrical components (20.1-20.9, 21.1-21.4, 22.1-22.4, 24.1-24.4, 26.1-26.4) of the fuse and/or relay type, said method comprising the steps of:
a) monitoring electrical quantities pertaining to said components (20.1-20.9, 21.1-21.4, 22.1-22.4, 24.1-24.4, 26.1-26.4) so as to check whether one of said components (20.1-20.9, 21.1-21.4, 22.1-22.4, 24.1-24.4, 26.1-26.4) is defective;
b) determining which is the defective component (20.3);
c) generating a first signal for the identification of the defective component (20.3);
d) selecting, among said components (20.1-20.9, 21.1-21.4, 22.1-22.4, 24.1-24.4, 26.1-26.4), at least one replacement component (20.9) adapted to operatively replace said defective component (20.3); and
e) generating a second signal for the identification of the at least one replacement component (20.9).

2. A method according to claim 1, wherein said selection step d) results in the selection of several replacement components (20.6, 20.7, 20.9).

3. A method according to claim 2, wherein said method also comprises the steps of:
f) assigning to several individual components (20.1-20.9, 21.1-21.4, 22.1-22.4, 24.1-24.4, 26.1-26.4) a rank representative of the importance of the electrical circuit (2.01, 2.11) to which this individual component (20.1-20.9, 21.1-21.4, 22.1-22.4, 24.1-24.4, 26.1-26.4) is connected;
g) comparing the respective ranks of the selected replacement components (20.6, 20.7, 20.9) for the identification of at least one replacement component (20.9) having the lowest possible rank.

4. A method according to claim 3, wherein said assignment step f) is performed only once before the beginning of the service life of the motor vehicle.

5. A method according to claim 3, wherein said assignment step f) is performed regularly during the service life of the motor vehicle, said rank depending on the operating conditions of the motor vehicle.

6. A method according to any preceding claim, wherein said method also comprises the steps of:
h) transmitting said first signal to an interface device (6) located in the motor vehicle, so as to provide the driver with the identification of the defective component (20.3);
i) transmitting said second signal to said interface device (6) located in the motor vehicle, so as to provide the driver with the identification of a replacement component (20.6, 20.7, 20.9).

7. A method according to any preceding claim, wherein said method also comprises the steps of:
j) transmitting said first signal to a receiver (9) remote from the motor vehicle, so as to provide an organization with the identification of the defective component (20.3);
k) transmitting said second signal to said receiver (9), so as to provide said organization with the identification of a replacement component (20.9).

8. A method according to any preceding claim, wherein said method also comprises the step of:
l) recording in a memory (32) data relating to the identification of the defective component (20.3), the identification of the selected replacement component (20.9), the date of defect and/or the completion of a replacement operation.

9. A method according to any preceding claim, wherein the monitoring step a), for a component (20.1, 21.1, 24), consists in measuring electrical tension and/or current at a predetermined test point (25.1, 25.2, 25.3, 35.1, 35.2) connected to said component (20.1-20.9, 21.1-21.4, 22.1-22.4, 24.1-24.4, 26.1-26.4).

10. A method according to claim 9, wherein, when a fuse is connected downwards of a relay (24), said electrical tensions and/or currents are measured when the relay (24) is in its conducting position.

11. A system for managing a junction box (2) arranged in a motor vehicle and having electrical components (20.1-20.9, 21.1-21.4, 22.1-22.4, 24.1-24.4, 26.1-26.4) of the fuse and/or relay type, said system comprising:
- means for monitoring (30) electrical quantities pertaining to said components (20.1-20.9, 21.1-21.4, 22.1-22.4, 24.1-24.4, 26.1-26.4) so as to check whether one of said components (20.1-20.9, 21.1-21.4, 22.1-22.4, 24.1-24.4, 26.1-26.4) is defective;
- means for determining (30) which is the defective component (20.3); and
- means for generating (30) a first signal for the identification of the defective component (20.3);
the system is **characterised in that** it further comprises:
- means for selecting (30), among said components (20.1-20.9, 21.1-21.4, 22.1-22.4, 24), at least one replacement component (20.9) adapted to operatively replace said defective component (20.3); and
- means for generating (30) a second signal for the identification of the at least one replacement component (20.9).

## Patentansprüche

1. Verfahren zur Handhabung eines Anschlusskastens (2), der in einem Kraftfahrzeug angeordnet ist und elektrische Komponenten (20.1-20.9, 21.1-21.4, 22.1-22.4, 24.1-24.4, 26.1-26.4) in Art einer Sicherung und/oder eines Relais aufweist, wobei das Verfahren die Schritte umfasst:
a) Überwachung elektrischer Quantitäten, die die Komponenten (20.1-20.9, 21.1-21.4, 22.1-22.4, 24.1-24.4, 26.1-26.4) betreffen, um zu prüfen, ob eine der Komponenten (20.1-20.9, 21.1-21.4, 22.1-22.4, 24.1-24.4, 26.1-26.4) defekt ist,
b) Bestimmen, welche die defekte Komponente (20.3) ist,
c) Erzeugen eines ersten Signals zur Identifizierung der defekten Komponente (20.3),
d) Auswahl wenigstens einer Ersatzkomponente (20.9) unter den Komponenten (20.1-20.9, 21.1-21.4, 22.1-22.4, 24.1-24.4, 26.1-26.4), die dazu ausgelegt ist, die defekte Komponente (20.3) funktionell zu ersetzen, und
e) Erzeugung eines zweiten Signals zur Identifizierung der wenigstens einen Ersatzkomponente (20.9).

2. Verfahren nach Anspruch 1, wobei der Auswahlschritt d) in der Auswahl mehrerer Ersatzkomponenten (20.6, 20.7, 20.9) resultiert.

3. Verfahren nach Anspruch 2, wobei das Verfahren außerdem die Schritte umfasst:
f) Zuweisen eines Rangs zu den mehreren einzelnen Komponenten (20.1-20.9, 21.1-21.4, 22.1-22.4, 24.1-24.4, 26.1-26.4), der für die Wichtigkeit des elektrischen Kreises (2.01, 2.11) repräsentativ ist, an den diese einzelne Komponente (20.1-20.9, 21.1-21.4, 22.1-22.4, 24.1-24.4, 26.1-26.4) angeschlossen ist,
g) Vergleichen der jeweiligen Ränge der gewählten Ersatzkomponenten (20.6, 20.7, 20.9) für die Identifizierung wenigstens einer Ersatzkomponente (20.9), die den geringstmöglichen Rang hat.

4. Verfahren nach Anspruch 3, wobei der Zuweisungsschritt f) nur einmal vor dem Beginn der Betriebslebensdauer des Fahrzeugs durchgeführt wird.

5. Verfahren nach Anspruch 3, wobei der Zuweisungsschritt f) während der Betriebslebensdauer des Fahrzeugs regelmäßig durchgeführt wird, wobei der Rang von den Betriebszuständen des Kraftfahrzeugs abhängt.

6. Verfahren nach irgendeinem vorhergehenden Anspruch, wobei das Verfahren außerdem die Schritte umfasst:
h) Übertragung des ersten Signals an eine Schnittstellenvorrichtung (6), die in dem Kraftfahrzeug angeordnet ist, um dem Fahrer die Identifizierung der defekten Komponente (20.3) bereitzustellen,
i) Übertragung des zweiten Signals an die in dem Kraftfahrzeug angeordnete Schnittstellenvorrichtung (6), um dem Fahrer die Identifizierung einer Ersatzkomponente (20.6, 20.7, 20.9) bereitzustellen.

7. Verfahren nach irgendeinem vorhergehenden Anspruch, wobei das Verfahren außerdem die Schritte umfasst:
j) Übertragung des ersten Signals an einen Empfänger (9), der von dem Kraftfahrzeug entfernt ist, um einer Organisation die Identifizierung der defekten Komponente (20.3) bereitzustellen,
k) Übertragung des zweiten Signals an den Empfänger (9), um der Organisation die Identifizierung einer Ersatzkomponente (20.9) bereitzustellen.

8. Verfahren nach irgendeinem vorhergehenden Anspruch, wobei das Verfahren außerdem die Schritte umfasst:
l) Aufzeichnung in einem Speicher (32) von Daten, die sich auf die Identifizierung der defekten Komponente (20.3), die Identifizierung der ausgewählten Ersatzkomponente (20.9), das Datum des Defekts und/oder die Vollziehung einer Ersatztätigkeit beziehen.

9. Verfahren nach irgendeinem vorhergehenden Anspruch, wobei der Überwachungsschritt a) für eine Komponente (20.1, 21.1, 24) in der Messung elektrischer Spannung und/oder Stroms an einer vorherbestimmten Teststelle (25.1, 25.2, 25.3, 35.1, 35.2) besteht, die mit der Komponente (20.1-20.9, 21.1-21.4, 22.1-22.4, 24.1-24.4, 26.1-26.4) verbunden ist.

10. Verfahren nach Anspruch 9, wobei, wenn eine Sicherung stromabwärts eines Relais (24) angeschlossen ist, die elektrischen Spannungen und/oder Ströme gemessen werden, wenn sich das Relais (24) in seiner Leitungsposition befindet.

11. System zur Handhabung eines Anschlusskastens (2), der in einem Kraftfahrzeug angeordnet ist und elektrische Komponenten (20.1-20.9, 21.1-21.4, 22.1-22.4, 24.1-24.4, 26.1-26.4) in Art einer Sicherung und/oder eines Relais aufweist, wobei das System umfasst:
- Einrichtungen zur Überwachung (30) elektrischer Quantitäten, die die Komponenten (20.1-20.9, 21.1-21.4, 22.1-22.4, 24.1-24.4, 26.1-26.4) betreffen, um zu prüfen, ob eine der Komponenten (20.1-20.9, 21.1-21.4, 22.1-22.4, 24.1-24.4, 26.1-26.4) defekt ist,
- Einrichtungen zur Bestimmung (30), welche die defekte Komponente (20.3) ist, und
- Einrichtungen zur Erzeugung (30) eines ersten Signals für die Identifizierung der defekten Komponente (20.3),
wobei das System **dadurch gekennzeichnet ist, dass** es außerdem umfasst:
- Einrichtungen zur Auswahl (30) wenigstens einer Ersatzkomponente (20.9) unter den Komponenten (20.1-20.9, 21.1-21.4, 22.1-22.4, 24.1-24.4, 26.1-26.4), die dazu ausgelegt ist, die defekte Komponente (20.3) funktionell zu ersetzen, und
- Einrichtungen zur Erzeugung (30) eines zweiten Signals zur Identifizierung der wenigstens einen Ersatzkomponente (20.9).

## Revendications

1. Procédé de gestion d'un boîtier de jonction (2) disposé dans un véhicule à moteur et comprenant des composants électriques (20.1-20.9, 21.1-21.4, 22.1-22.4, 24.1-24.4, 26.1-26.4) du type fusible et/ou relai, lequel procédé comprend les étapes consistant à :
a) contrôler des quantités électriques concernant lesdits composants (20.1-20.9, 21.1-21.4, 22.1-22.4, 24.1-24.4, 26.1-26.4) afin de vérifier si un des composants (20.1-20.9, 21.1-21.4, 22.1-22.4, 24.1-24.4, 26.1-26.4) est défectueux ;
b) déterminer le quel des composant0073 est le composant défectueux (20.3);
c) générer un premier signal pour identifier le composant défectueux (20.3) ;
d) choisir parmi lesdits composants (20.1-20.9, 21.1-21.4, 22.1-22.4, 24.1-24.4, 26.1-26.4) au moins un composant de rechange (20.9) conçu pour remplacer fonctionnellement ledit composant défectueux (20.3) ; et
e) générer un second signal pour identifier ledit au moins un composant de rechange (20.9).

2. Procédé selon la revendication 1, dans lequel ladite étape de sélection d) se traduit par la sélection de plusieurs composants de rechange (20.6, 20.7, 20.9).

3. Procédé selon la revendication 1, lequel comprend également les étapes consistant à :
f) attribuer à plusieurs composants individuels (20.1-20.9, 21.1-21.4, 22.1-22.4, 24.1-24.4, 26.1-26.4) un rang représentant l'importance du circuit électrique (2.01, 2.11) auquel ce composant individuel (20.1-20.9, 21.1-21.4, 22.1-22.4, 24.1-24.4, 26.1-26.4) est connecté ; et
g) comparer les rangs respectifs des composants de rechange choisis (20.6, 20.7, 20.9) afin d'identifier au moins un composant de rechange (20.9) ayant le rang le plus bas possible.

4. Procédé selon la revendication 3, dans lequel l'étape d'attribution f) est effectuée une seule fois avant le début de la vie opérationnelle du véhicule à moteur.

5. Procédé selon la revendication 3, dans lequel l'étape d'attribution f) est effectuée régulièrement au cours de la vie opérationnelle du véhicule à moteur, le rang dépendant des conditions de fonctionnement du véhicule à moteur.

6. Procédé selon l'une quelconque des revendications précédentes, lequel procédé comprend également les étapes consistant à :
h) transmettre ledit premier signal à un dispositif d'interface (6) situé dans le véhicule à moteur de manière à fournir au conducteur l'identification du composant défectueux (20.3) ; et
i) transmettre ledit second signal audit dispositif d'interface (6) situé dans le véhicule à moteur de manière à fournir au conducteur l'identification d'un composant de rechange (20.6, 20.7, 20.9).

7. Procédé selon l'une quelconque des revendications précédentes, lequel procédé comprend également les étapes consistant à :
j) transmettre ledit premier signal à un récepteur (9) distant du véhicule à moteur de manière à fournir à une organisation l'identification du composant défectueux (20.3) ; et
k) transmettre ledit second signal audit récepteur (9) de manière à fournir à l'organisation l'identification d'un composant de rechange (20.9).

8. Procédé selon l'une quelconque des revendications précédentes, lequel procédé comprend également l'étape consistant à :
1) enregistrer dans une mémoire (32) des données concernant l'identification du composant défectueux (20.3), l'identification du composant de rechange choisi (20.9), la date de la défaillance et/ou la fin d'une opération de remplacement.

9. Procédé selon l'une quelconque des revendications précédentes, dans lequel l'étape de contrôle a), pour un composant (20.1, 21.1, 24) consiste à mesurer la tension et/ou le courant électriques en un point de test prédéterminé (25.1, 25.2, 25.3, 35.1, 35.2) connecté audit composant (20.1-20.9, 21.1-21.4, 22.1-22.4, 24.1-24.4, 26.1-26.4).

10. Procédé selon la revendication 9, dans lequel, lorsqu'un fusible est connecté en aval d'un relai (24), les tensions et/ou courants électriques sont mesurés lorsque le relai (24) est en position de conduction.

11. Système de gestion d'un boîtier de jonction (2) disposé dans un véhicule à moteur et comprenant des composants électriques (20.1-20.9, 21.1-21.4, 22.1-22.4, 24.1-24.4, 26.1-26.4) du type fusible et/ou relai, lequel système comprend :
- des moyens pour contrôler (30) des quantités électriques concernant lesdits composants (20.1-20.9, 21.1-21.4, 22.1-22.4, 24.1-24.4, 26.1-26.4) afin de vérifier si un des composants (20.1-20.9, 21.1-21.4, 22.1-22.4, 24.1-24.4, 26.1-26.4) est défectueux ;
- des moyens pour déterminer (30) lequel des composants est le composant défectueux (20.3) ; et
- des moyens pour générer (30) un premier signal pour identifier le composant défectueux (20.3) ;
lequel système est **caractérisé en ce qu'**il comprend en outre :
- des moyens pour choisir (30), parmi lesdits composants (20.1-20.9, 21.1-21.4, 22.1-22.4, 24), au moins un composant de rechange (20.9) conçu pour remplacer fonctionnellement ledit composant défectueux (20.3) ; et
- des moyens pour générer (30) un second signal pour identifier ledit au moins un composant de rechange (20.9).
